# EUROPÄISCHE PATENTSCHRIFT

(11) **EP 1 832 340 B1**
(45) Veröffentlichungstag und Bekanntmachung des Hinweises auf die Patenterteilung: **06.01.2010**
(21) Anmeldenummer: 06090034.7
(22) Anmeldetag: 08.03.2006
(51) Int. Cl.: B01J 19/08, C23C 16/04, C23C 16/511, C23F 4/00, C23G 5/00

(54) **Verfahren und Vorrichtung zum partiellen Behandeln der Oberfläche mindestens eines Bauteils mit in mindestens einer Vakuumkammer zu erzeugendem Niederdruckplasma**
Process and device for partial surface treatment of a component by low pressure plasma generated in a vacuum chamber
Procédé et dispositif de traitement partiel d'une surface d'un composant avec un plasma à basse pression généré dans une chambre à vide

(43) Veröffentlichungstag der Anmeldung: 12.09.2007
(73) Patentinhaber: INPRO Innovationsgesellschaft für fortgeschrittene Produktionssysteme in der Fahrzeugindustrie mbH, 10587 Berlin (DE)
(72) Erfinder: Stechmann, Lea, INPRO GmbH, 10587 Berlin (DE); Minkow, Michael, 13593 Berlin (DE); Hoyer, Olaf, 16727 Schwante (DE)
(74) Vertreter: Hoffmann, Klaus-Dieter

(56) Entgegenhaltungen:
- EP-A2- 0 492 511
- DE-A1- 4 218 196
- DE-A1- 10 332 921
- DE-C1- 4 401 718
- JP-A- 2 267 290

## Beschreibung

Die Erfindung betrifft ein Verfahren zum partiellen Behandeln der Oberfläche mindestens eines Bauteils mit Niederdruckplasma, das in mindestens einer mit einer Öffnung versehenen Reaktorkammer zu erzeugen ist, wobei die Öffnung der Reaktorkammer verschlossen wird und die Reaktorkammer dann evakuiert und mit einem Prozeßgas gefüllt wird, das durch Energieeintrag in die Reaktorkammer in dieser unter Bildung des Niederdruckplasmas ionisiert und auf dem zu behandelnden Teil der Bauteiloberfläche zur Einwirkung gebracht wird.

Die Erfindung betrifft weiterhin eine Vorrichtung zum partiellen Behandeln der Oberfläche eines Bauteils mit Niederdruckplasma, die mindestens eine mit einer Öffnung versehene, verschließbare Reaktionskammer aufweist, die über jeweils eine Ventileinrichtung aufweisende Leitungen mit einer Vakuumpumpe und einem Prozessgasbehälter verbunden ist, von der bzw dem die Reaktionskammer zu evakuieren bzw mit dem Prozessgas zu füllen ist, und an der außerhalb ein Plasmagenerator vorgesehen ist, mittels dem das in die evakuierte Reaktionskammer gefüllte Prozessgas unter Bildung des Niederdruckplasmas in der Reaktionskammer zu ionisieren ist, so dass das ionisierte Prozessgas auf ein zu behandelndes Teil der Bauteiloberfläche einwirken kann

Aus der DE 103 32 921 A1 sind ein Verfahren und eine Vorrichtung zum Behandeln der Oberfläche von Bauteilen mit Niederdruckplasma in einer mit Prozessgas füllbaren, eine Öffnung aufweisenden Vakuumkammer bekannt, wobei die Öffnung der Vakuumkammer vor dem Evakuieren und dem Einbringen sowie der Ionisation des Prozessgases mittels einer in der Vakuumkammer angeordneten und an einen Plasmagenerator angeschlossenen Elektrode von dem Teil der zu behandelnden Bauteiloberfläche dicht verschlossen wird Dieses bekannte Vierfahren soll für großflächige Bauteile mit vertretbarem Anlageaufwand einsetzbar sein Hierzu wird eine das Bauteil oder die Vakuumkammer bewegende Vorrichtung verwendet, mit der eine Relativbewegung zwischen Bauteiloberfläche und der Öffnung der Vakuumkammer ausgeführt wird, bis die gesamte zu behandelnde Oberfläche des Bauteils einer Behandlung unterzogen worden ist Da das Bauteil während der Behandlung des Teils der Bauteiloberfläche, das die Öffnung der Vakuumkammer verschließt, an einem die Öffnung der Vakuumkammer umgebenden Dichtungselement wegen des in der Vakuumkammer herrschenden Unterdrucks festgehalten wird, ist vor einer erneuten relativen Bewegung von Bauteil und Bewegungsvorrichtung nach erfolgter Behandlung des Teils der Bauteiloberfläche der Unterdruck in der Vakuumkammer aufzuheben.

Bekannt ist weiterhin der Einsatz einer Plasmareaktorkammer (EP 0492 511 B1; DE 691 13 231 T2), die eine Bchandlungsflächenöffnung in der Kammer aufweist, wobei eine Vakuumdichtung, die auf der Wand der Reaktorkammer vorgesehen ist, die Öffnung umgibt Zur Erzeugung eines Plasmas innerhalb der Kammer wird eine an der Innenfläche der Kammerwand vorgesehene HF-Elektrode verwendet, wobei das Plasma innerhalb der Kammer mit einem niedrigen Druck unter Verwendung einer geeigneten Gasatmosphäre erzeugt wird Für eine gute Manövrierfähigkeit der Reaktorkammer sind eine Vakuumpumpe, ein HF-Generator und eine Plasmaquelle in einer Steuerkonsole angeordnet, die über entsprechende Versorgungsleitungen mit der Reaktorkammer verbunden sind, die manuell oder mittels eines Roboters an verschiedenen Stellen der Bauteiloberfläche zur Behandlung des die Öffnung der Kammer jeweils verschließenden Teils der Bauteiloberfläche aufgesetzt werden kann Auch hier ist jedoch stets eine Aufhebung des Unterdrucks in der Reaktorkammer vor deren Versetzen auf der Bauteiloberfläche erforderlich

Im Bereich der Niedertemperatur-Plasmatechnologie findet heutzutage weitgehend die unter Vakuumbedingungen stattfindende Niederdruckplasmatechnologie Verwendung, wobei es sich somit immer um ein Batch-Verfahren handelt Wenn eine Inline-Integration in eine Fertigungslinie gewünscht wird, so ist diese nur mit anspruchsvollen Schleusensystemen möglich

Bekannt ist ist weiterhin ein Verfahren und eine Vorrichtung zum partiellen Behandeln der Oberfläche eines Bauteils mit einem Niederdruckplasma (JP 02 267290A), wobei das Innere einer Behandlungseinrichtung evakuiert, ein Prozessgas in die Behandlungseinrichtung eingefüllt und durch Energieeintrag in dieser unter Bildung des Niederdruckplasmas ionisiert und das ionisierte Prozessgas auf einen Teil der Oberfläche des an der unter Vakuum stehenden Behandlungseinrichtung zu positionierenden Bauteils zur Einwirkung gebracht wird Hierbei ist eine eine Öffnung umfassende Prozessglocke beweglich über eine flexible Zuleitung mit einer unter Vakuum stehenden Kammer gekoppelt Die Öffnung der Prozessglocke wird durch das zu behandelnde Teil der Oberfläche des Bauteils abdichtend verschlossen, worauf die Prozessglocke evakuiert wird und die ionisierten Teilchen des Prozessgases aus der Vakuumkammer durch die mit dieser kommunizierenden flexiblen Zuleitung in die Prozessglocke geleitet und in dieser auf das behandelnde Teil der Bauteiloberfläche zur Einwirkung gebracht wird Nach Beendigung der Behandlung des entsprechenden Teils der Bauateiloberfläche ist die Evakuierung der Prozessglocke aufzuheben, bevor die Prozessglocke an eine andere Position der Bauteiloberfläche zu deren weiterer lokaler Behandlung bewegt werden kann, was verhältnismäßig zeitaufwendig ist.

Ziel der Erfindung ist daher, eine ortsflexible zeit- und kostengünstige Behandlung lokaler Bereiche von Bauteiloberflächen mit Niederdruckplasma, insbesondere zur fortlaufenden gezielten Aktivierung, Reinigung und/oder Beschichtung automobiler Anbauteile, wobei eine Inhne-Integration der lokalen Behandlung von Bauteiloberflächen durch ständiges Aufrechterhalten des Niederdruckplasmas von Interesse ist.

Der Erfindung liegt daher die Aufgabe zugrunde, ein Verfahren und eine Vorrichtung zur partiellen Behandlung der Oberfläche mindestens eines Bauteils mit Niederdruckplasma gemäß der eingangs erwähnten Art zur Verfugung zu stellen derart, daß die Nachteile des Standes der Technik überwunden werden und eine ununterbrochene gezielte Behandlung mindestens eines Bauteils oder gleichzeitig mehrerer lokaler Bereiche des Bauteils auch mit unterschiedlich angestrebten Resultaten bei gleichzeitiger Ermöglichung einer inlinefähigen lokalen Oberflächenbehandlung gewährleistet ist

Diese Aufgabe wird verfahrensmäßig erfindungsgemäß dadurch gelöst, dass
- mindestens ein portabler autarker miniaturisierter offener ND-Plasma-Reaktor verwendet wird,
- wobei die Öffnung der Reaktionskammer vor Aufnahme der Oberflächenbehandlung durch eine in eine Schliessstellung zu bewegende Verschlusseinrichtung dicht verschlossen gehalten wird, worauf
- das Prozessgas in die von der Verschlusseinrichtung verschlossene Reaktionskammern gefüllt und in dieser mittels Mikrowellenanregung ionisiert wird,
- die Verschlusseinrichtung dann in eine die Öffnung der Reaktionskammer freigebende Stellung bewegt wird, in der die Öffnung der Reaktionskammer nunmehr fortgesetzt von dem zu behandelnden Teil der Oberfläche des Bauteils dicht verschlossen gehalten wird und das ionisierte Prozessgas auf dem zu behandelnden Teil der Bauteiloberfläche zur Einwirkung kommt,
- die Verschlusseinrichtung nach erfolgter Behandlung des die Öffnung der Reaktionskammer verschliessenden Teils der Bauteiloberfläche in ihre Schliessstellung zurückbewegt wird und
- dann der miniaturisierte ND-Plasma-Reaktor ohne Abschattung des in der Reaktionskammer erzeugten Niederdruckplasmas zur unmittelbar fortgesetzten partiellen Behandlung der Bauteiloberfläche an anderer Stelle in Position gebracht wird

Bevorzugt werden die Abmessungen der Reaktionskammer des miniaturisierten ND-Plasma-Reaktors hinsichtlich ihrer Länge, Breite und Höhe im Bereich von 10 mm bis 100 mm bzw 10 mm bis 100 mm bzw 10 mm bis 100 mm und der Einsatzdruck in der Reaktionskammer des miniaturisierten ND-Plasma-Reaktors im Bereich von 1 Pa bis 1000 Pa gewählt

Der miniaturisierte ND-Plasma-Reaktor kann robotergesteuert bewegt werden, wobei die Verschlußeinrichtung der Öffnung der Reaktionskammer des miniaturisierten ND-Plasma-Reaktors ebenfalls robotergesteuert in die Schliess- und die Freigabestellung bewegt werden kann. Als Verschlusseinrichtung kann eine Schiebetür oder ein Shutter verwendet werden, Auch ist es möglich, daß der miniaturisierte ND-Plasma-Reaktor vor oder nach Schliessen der Öffnung der Reaktionskammer mittels Luftkissen über die Oberfläche des Bauteils bewegt wird Ferner können mehrere miniaturisierte ND-Plasma-Reaktoren gleichzeitig auf der Oberfläche des Bauteils zu deren partiellen Behandlung bewegt werden.

Es kann auch jeweils ein portabler autarker miniaturisierter ND-Plasma-Reaktor auf den gegenüberliegenden Flächen einer verhältnismäßig dünnen opaken Platte aus Polyethylen zu deren Behandlung gleichzeitig eingesetzt werden, wobei Luft als Trägermedium in der mit der Vakuumpumpe und dem Prozessgasbehälter kommunizierenden Reaktionskammer des jeweiligen portablen autarken miniaturisierten ND-Plasma-Reaktors verwendet werden kann Der Nachweis erfolgt einerseits durch die optische Erkennbarkeit des Plasmabrandes durch die dünne opake Polyethylenplatte und andererseits durch die Darstellung der veränderten Benetzbarkeit der behandelten Oberfläche durch eine Testtinte In entsprechender Weise sind auch Beschichtungs. Ätz- und Reinigungsprozesse möglich

Die Aufgabe der Erfindung wird weiterhin erfindungsgemäß gelöst durch die eingangs genannte Vorrichtung zum partiellen Behandeln der Oberfläche mindestens eines Bauteils mit Niederdruckplasma, die dadurch gekennzeichnet ist, das
- mindestens ein autarker portabler miniaturisierter ND-Plasma-Reaktor verfügbar ist, bei dem
- an der Reaktionskammer eine Verschlusseinrichtung vorgesehen ist, die in eine die Reaktionskammer dicht verschliessende Verschlussstellung zu bewegen ist, in der die Reaktionskammer zu evakuieren und mit Prozessgas zu füllen ist,
- der Plasmagenerator ein Mikrowellen- oder Radiofrequenzgenerator ist, von dem das Prozessgas in der von der Verschlusseinrichtung dicht verschlossenen Reaktionskammer zu ionisieren ist, und
- die Verschlusseinrichtung in eine die Öffnung der Reaktionskammer freigebende Stellung zu bewegen ist, in der die Öffnung der Reaktionskammer fortgesetzt durch das zu behandelnde Teil der Bauteiloberfläche dicht verschlossen gehalten und das zu behandelnde Teil zugleich der Wirkung der ionisierten Prozessgasteilchen ausgesetzt ist und
- aus der die Verschlusseinrichtung nach erfolgter Behandlung des die Öffnung dicht verschliessenden Teils der Bauteiloberfläche in die ihrerseits die Reaktionskammer wieder abdichtend verschliessende Stellung zurückzubewegen ist, in der der miniaturisierte ND-Plasma-Reaktor ohne Abschaltung des in der Reaktionskammer erzeugten Niedruckplasmas zur unmittelbar fortgesetzten partiellen Behandlung der Bauteiloberfläche an anderer Stelle in Position zu bringen ist.

Vorteilhafte Weiterbildungen der erfindungsgemäßen Vorrichtung ergeben sich aus den Patentansprüchen 11 bis 19

Die Erfindung ermöglicht in effektiver und kostensparender Weise die ununterbrochene gleichzeitige Behandlung verschiedener lokaler Bereiche insbesondere automobiler Anbauteile zur Aktivierung, Reinigung und/oder Beschichtung mittels Niederdruckplasma. Durch die Möglichkeit des ständigen Aufrechterhaltens des ND-Plasmas ist eine inlinefähige lokale Behandlung verschiedener Bauteiloberflächen gewährleistet. Die Größe und Konfiguration der Reaktionskammer des portablen, autarken, miniaturisierten ND-Plasma-Reaktors ist Abhängigkeit von der Größe des zu behandelnden Teils der Bauteiloberfläche und von deren Krümmungsradius oder von der Größe des Bauteils zu wählen. Die Dichtungen der Reaktionskammer des miniaturisierten ND-Plasma-Reaktors sind an die Rauhigkeit der zu behandelnden Bauteiloberfläche anzupassen Entsprechend ist die Rauhigkeit der Bauteiloberfläche bei der Auslegung der Reaktionskammer wie der Vakuumpumpe zu berücksichtigen. Vorteilhaft erweist sich, daß aufgrund des geringen Volumens der Reaktionskammer des miniaturisierten ND-Plasma-Reaktors die Abpumpzeiten im Vergleich zu herkömmlichen Niederdruckplasmaverfahren äußerst gering sind.

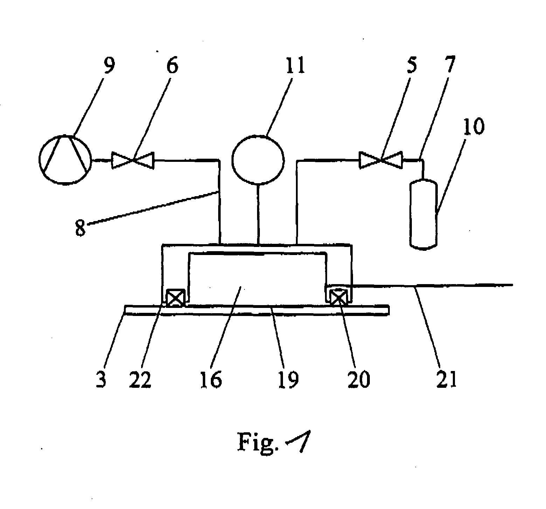

Die Erfindung wird nun anhand der Zeichnungen erläutert In diesen sind
**Fig. 1** eine schematische Darstellung eine ersten Ausführungsform der erfindungsgemäßen Vorrichtung in Form eines portablen autarken miniaturisierten ND-Plasma-Reaktors bei Positionierung der Verschlußeinrichtung für die Öffnung der Reaktionskammer des miniaturisierten ND-Plasma-Reaktors in der Freigabestellung,

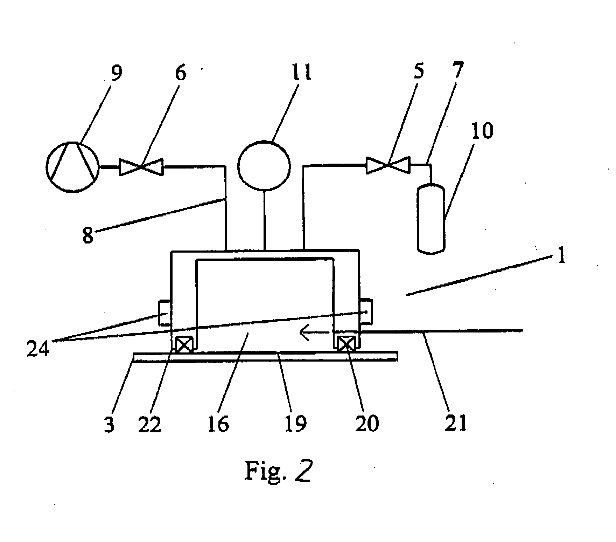

**Fig. 2** eine der in Fig. 1 dargestellten Ausführungsform entsprechende zweite Ausführungsform der Vorrichtung bei Positionierung der Verschlußeinrichtung für die Öffnung der Reaktionskammer des miniaturisierten ND-Plasma-Reaktors in der Freigabestellung, wobei Druckluftdüsen an der Außenwand der Reaktionskammer zur Erzeugung eines Luftkissens vorgesehen sind,

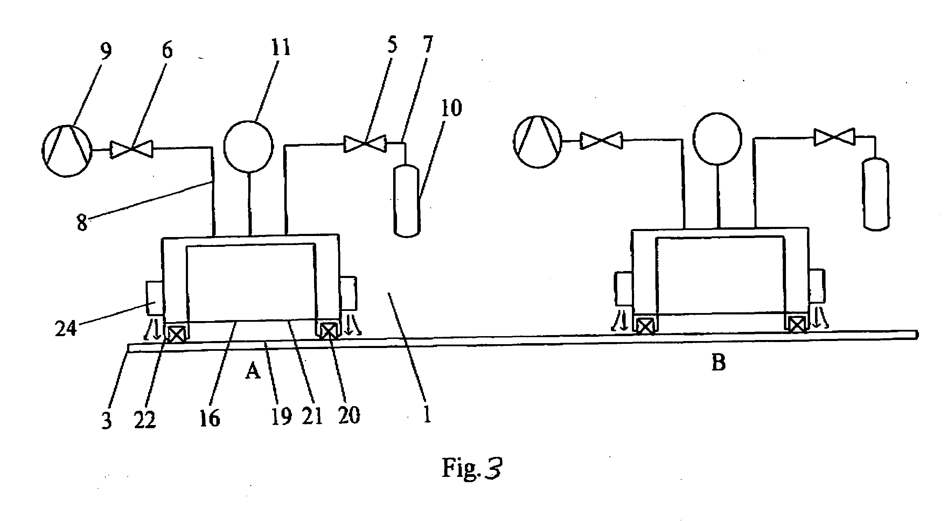

**Fig. 3** eine Darstellung der Ausführungsform gemäß Fig. 2 bei Positionierung der Verschlußeinrichtung für die Öffnung der Reaktionskammer des miniaturisierten ND-Plasma-Reaktors in der Verschlußstellung, wobei der miniaturisierte ND-Plasma-Reaktor in einem Behandlungsort A und in einem Behandlungsort B gezeigt ist, in den der ND-Plasma-Reaktor durch Relativbewegung zur Bauteiloberfläche mittels des Luftkissens versetzt worden ist, und

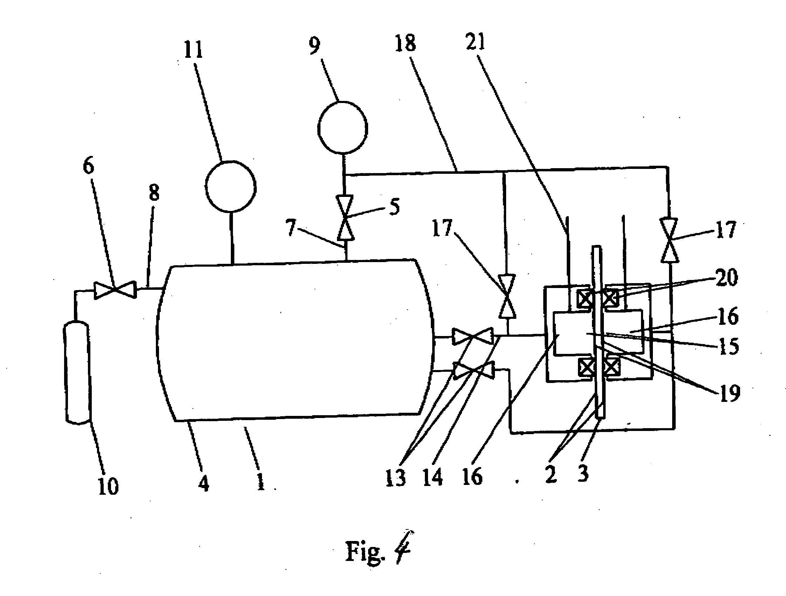

**Fig. 4** eine der Darstellung nach Fig 1 entsprechende dritte Ausführungsform in Form des portablen autarken miniaturisierten ND-Plasma-Reaktors, jedoch mit zwei Reaktionskammern, die jeweils über eine Vakuumkammer mit der Vakuumpumpe und dem Prozessgasbehälter verbunden sind und mit denen jeweils die einander gegenüberliegenden Oberflächen des in Fig 1 gezeigten plattenförmigen Bauteils zu behandeln sind.

Aus Fig. 1 geht in schematischer Darstellung eine erste Ausführungsform der erfindungsgemässen Vorrichtung zum partiellen Behandeln der Oberfläche 2 eines Bauteils 3 mit Niederdruckplasma in Form eines portablen autarken miniaturisierten ND-Plasma-Reaktors 1 hervor, der eine mit einer Öffnung 15 versehene Reaktionskammer 16 aufweist, an der eine Verschlusseinrichtung 21 in Form eines Schiebers oder Shutters für die Öffnung 15 der Reaktionskammer 16 vorgesehen ist Die Verschlusseinrichtung 21 ist z.B manuell oder robotisch in ihre die Öffnung 15 verschliessende oder freigebende Stellung zu bewegen. In der Schliessstellung der Verschlusseinrichtung 21 ist die Reaktionskammer 16 von einer Vakuumpumpe 9, die mit der Reaktionskammer 16 über eine ein Ventil 5 aufweisende Leitung 7 verbunden ist, zu evakuieren Die evakuierte Reaktionskammer 16 ist dann mit Prozessgas aus einem Prozessgasbehätter 10 über eine ein Ventil 6 aufweisende Leitung 8 zu füllen, die mit der Reaktionskammer 16 verbunden ist. Zur lokalen Behandlung der Bauteiloberfläche 2 ist der miniaturisierte ND-Plsma-Reaktor I auf das zu behandelnde Teil 19 aufzusetzen, wobei eine die Öffnung 15 der Reaktionskammer 16 umfassende Dichtung 20 für eine gesicherte Abdichtung zwischen den auf der Bauteiloberfläche 2 aufgesetzten Stirnkanten 22 der Reaktionskammer 16 und dem zu behandelnden Teil 19 der Bauteiloberfläch 2 sorgt Zur Behandlung des Teils 19 der Bauteiiloberfläche 2 ist die Verschlusseinrichtung 21 für die Öffnung 15 der Reaktionskammer 16 dann in ihre Freigabestellung zu bewegen, wobei die Öffnung 15 fortgesetzt durch das zu behandelnde teil 19 der Bauteiloberfläche 2 abgedichtet verschlossen bleibt, das dann unmittelbar der Einwirkung des Niederdruckplasmas in der Reaktionskammer 16 des miniaturisierten ND- Plasma-Reaktors 1 zwecks Behandlung ausgesetzt ist. Nach erfolgter Behandlung des Teils 19 der Bauteiloberfläche 2 ist die Öffnung 15 der Reaktionskammer 16 erneut von der Verschlusseinrichtung 20 durch deren Bewegung in ihre Schliessstellung zu verschliessen, so daß der miniaturisierte ND-Plasma-Reaktor 1 ohne Abschaltung der Niederdruckplasmas in der Reaktionskammer 16 zur kontinuierlich fortgesetzten partiellen Behandlung eines anderen Teils der Bauteiloberfläche 2 zu versetzen ist Eine entsprechende Behandlung anderer Bauteilgeometrien als die des in Fig 1 dargestellten plattenförmigen Bauteils 1 ist selbstverständlich möglich

Aus den Fig. 2 und 3 geht eine der Fig. 1 entsprechende zweite Ausführungsform der erfindungsgemässen Vorrichtung in Form des portablen autarken miniaturisierten ND-Plasma-Reaktors 1 hervor, bei der an der Außenwand 23 der Reaktionskammer 16 in Nähe deren auf die Bauteiloberfläche 2 aufzusetzenden Stirnkanten 22 Druckluftdüsen 24 vorgesehen sind, mittels der ein Luftkissen zu erzeugen ist Mit diesem Luftkissen kann zur schonenden Behandlung der Bauteiloberfläche 2 für eine Relativbewegung zwischen letzterer und dem ND-Plasma-Reaktor 1 nach erfolgter Behandlung des Teils 19 der Bauteiloberfläche 2 und Verschliessen der Öffnung 15 der Reaktionskammer 16 aus Position A in Fig 3 gesorgt werden, so daß eine Versetzung des miniaturisierten ND-Plasma-Reaktors z.B in die Position B gemäß Fig 3 ohne Abschaltung des Niederdruckplasmas möglich ist, um eine entsprechende partielle Behandlung der Bauteiloberfläche 2 fortzusetzen

Bei den Ausfuhrungsformen der erfindungsgemässen Vorrichtung nach den Fig 1 bis 3 ist zudem wegen der Plasmaanregung mittels Mikrowellen für eine geeignete Metallvergitterung entweder des gesamten miniaturisierten ND-Plasmareaktors oder des Dichtungsbereiches der Reaktionskammer an der Bauteiloberfläche zu sorgen.

Fig 4 zeigt schematisch eine der Fig 1 entsprechende dritte Ausführungsform des portablen autarken miniaturisierten ND-Plasma-Reaktors 1, wobei über eine Vakuumkammer 4 zwei Reaktionskammern 16 über jeweils eine flexible Zuleitung 14 mit dem Prozessgasbehälter 10 sowie der Vakuumpumpe 9 verbunden sind Von den beiden Reaktionskammern 16 sind die einander gegenüberliegenden Flächen des plattenförmigen Bauteils in Übereinstimmung mit dem im Zusammenhang mit Fig 1 beschriebenen Verfahren gleichzeitig und ununterbrochen partiell mit Niederdruckplasma zu behandeln. Entsprechend kann der portable autarke miniaturisierte ND-Plasma-Reaktor 1 mit mehr als zwei Reaktionskammern 16 ausgerüstet sein, so dass auch die Oberflächen 2 unterschiedlicher Bauteile 3 gleichzeitig und ununterbrochen lokal zu behandeln sind

### Liste der Bezugszeichen:

- 1: ND-Plasma-Reaktor
- 2: Oberfläche des Bauteils
- 3: Bauteil
- 4: Vakuumkammer
- 5: Ventil
- 6: Ventil
- 7: Leitung
- 8: Leitung
- 9: Vakuumpumpe
- 10: Prozeßgasbehälter
- 11: MikrowellengeneratorElektrode für Radiofrequenzanregung
- 13: Ventil
- 14: Zuteilung
- 1 5: Öffnung
- 16: Reaktionskammer
- 17: Ventil
- 18: Leitung
- 19: Teil der Oberfläche
- 20: Dichtung
- 21: Verschlußeinrichtung
- 22: Stirnkanten der Reaktionskammer
- 23: Außenwand der Reaktionskammer
- 24: Druckluftdüsen
- A, B: Position des ND-Plasma-Reaktors

## Patentansprüche

1. Verfahren zum partiellen Behandeln der Oberfläche mindestens eines Bauteils mit Niederdruckplasma, das in mindestens einer mit einer Öffnung versehenen Reaktionskammer zu erzeugen ist, wobei die Öffnung der Reaktionskammer verschlossen und die Reaktionskammern dann evakuiert und mit einem Prozessgas gefüllt wird, das durch Energieeintrag in die Reaktionskammer in dieser unter Bildung des Niederdruckplasmas ionisiert und auf dem zu behandelnden Teil der Bauteiloberfläche zur Einwirkung gebracht wird,
**dadurch gekennzeichnet, dass**
- mindestens ein portabler autarker miniaturisierter offener ND-Plasma-Reaktor verwendet wird,
- wobei die Öffnung der Reaktionskammer des ND-Plasma-Reaktors vor Aufnahme der Oberflächenbehandlung durch eine in eine Schliessstellung zu bewegende Verschlusseinrichtung dicht verschlossen gehalten wird, worauf
- das Prozessgas in die von der Verschlusseinrichtung verschlossene Reaktionskammer gefüllt und in dieser mittels Mikrowellenanregung ionisiert wird,
- die Verschlusseinrichtung dann in eine die Öffnung der Reaktionskammer freigebende Stellung bewegt wird, in der die Öffnung der Reaktionskammernunmehr fortgesetzt von dem zu behandelnden Teil der Bauteiloberfläche dicht verschlossen gehalten wird und das ionisierte Prozessgas auf dem zu behandelnden Teil der Bauteiloberfläche zur Einwirkung kommt,
- die Verschlussemrichtung nach erfolgter Behandlung des die Öffnung der Reaktionskammer verschliessenden Teils der Bauteiloberfläche in ihre Schliessstellung zurückbewegt wird und
- dann der miniaturisierte ND-Plasma-Reaktor ohne Abschattung des in der Reaktionskammer erzeugten Niederdruckptasmas zur unmittelbar fortgesetzten partiellen Behandlung eines anderen Teils der Bauteiloberfläche in die entsprechende Position gebracht wird.

2. Verfahren nach Anspruch 1, **dadurch gekennzeichnet, daß** die Abmessungen der Reaktionskammer des portablen autarken miniaturisierten ND-Plasma-Reaktors hinsichtlich ihrer Lange, Breite und Höhe im Bereich von 10 mm bis 100 mm bzw 10 mm bis 100 mm bzw. 10 mm bis 100 mm gewählt werden.

3. Verfahren nach Anspruch 1 und 2, **dadurch gekennzeichnet, daß** der Einsatzdruck in der Reaktionskammern des portablen autarken miniaturisierten ND-Plasma-Reaktors im Bereich von 1 Pa bis 1000 Pa gewählt wird.

4. Verfahren nach Anspruch 1 bis 3, **dadurch gekennzeichnet, daß** der portable autarke miniaturisierte ND-Plasma-Reaktor robotergesteuert bewegt wird.

5. Verfahren nach Anspruch 4, **dadurch gekennzeichnet, daß** die Verschlusseinrichtung für die Öffnung der Reaktionskammer des portablen autarken miniaturisierten ND-Plasma-Reaktors robotergesteuert in die Schliess- und die Freigabestellung bewegt wird.

6. Verfahren nach einem der vorhergehenden Ansprüche, **dadurch gekennzeichnet, dass** als Verschlusseinrichtung ein Schiebetür oder ein Shutter verwendet wird.

7. Verfahren nach einem der Ansprüche 1 bis 6, **dadurch gekennzeichnet, daß** der portable autarke miniaturisierte ND-Plasma-Reaktor vor oder nach Schliessen der Öffnung der Reaktionskammer mittels Luftkissen relativ zu Oberfläche des Bauteils bewegt wird.

8. Verfahren nach einem der Ansprüche 1 bis 7, **dadurch gekennzeichnet, daß** die Reaktionskammern mehrerer portable autarker miniaturisierter ND-Plasma-Reaktoren gleichzeitig auf der Oberflache des Bauteils oder verschiedener Bauteile zu deren partiellen Behandlung bewegt werden.

9. Verfahren nach einem der vorhergehenden Ansprüche, **dadurch gekennzeichnet, dass** jeweils ein portabler autarker miniaturisierter ND-Plasma-Reacktor auf den gegenüberliegenden Flächen einer verhältnismäßig dünnen opaken Platte aus Polyethylen zu deren Behandlung gleichzeitig eingesetzt wird, wobei Luft als Trägermedium in der mit der Vakuumpumpe und dem Prozessgasbehälter kommunizierenden Reaktionskammer des jeweiligen portablen autarken miniaturisierten ND-Plasma-Reaktors verwendet wird.

10. Vorrichtung zum partiellen Behandeln der Oberfläche (2) eines Bauteils (3) mit Niederdruckplasma, die mindestens eine mit einer Öffnung (15) versehene, verschliessbare Reaktionskammer (16) aufweist, die über jeweils eine Ventileinrichtung (5, 6) aufweisende Leitungen (7, 8) mit einer Vakuumpumpe (9) und mit einem Prozessgasbehälter (10) verbunden ist, von der bzw dem die Reaktionskammer (16) zu evakuieren bzw mit Prozessgas zu füllen ist, und an der außerhalb ein Plasmagenerator (11) vorgesehen ist, mittels dem das in die evakuierte Reaktionskammer (16) gefüllte Prozessgas unter Bildung des Niederdruckplasmas in der Reaktionskammer (16) zu ionisieren ist, so dass das ionisierte Prozessgas auf ein zu behandelndes Teil (19) der Bauteiloberfläche (2) einwirken kann,
**dadurch gekennzeichnet, dass**
- mindestens ein portabler autarker miniaturisierter ND-Plasma-Reaktor (1) verfügbar ist, bei dem
- an der Reaktionskammer (16) eine Verschlusseinrichtung (21) vorgesehen ist, die in eine die Öffnung (15) die Reaktionskammer (16) dicht verschliessende Verschlussstellung zu bewegen ist, in der die Reaktionskammer (16) zu evakuieren und mit Prozessgas zu füllen ist,
- der Plasmagenerator (11) ein Mikrowellen-, Radiofrequenzwellen- oder anderer HF-Generator ist, von dem das Prozessgas in der von der Verschlusseinrichtung (21) dicht verschlossenen Reaktionskammer (16) zu ionisieren ist, und
- die Verschlusseinrichtung, (21) in eine die Öffnung (15) der Reaktionskammer (16) freigebende Stellung zu bewegen ist, in der die Öffnung (15)der Reaktionskammer (16) fortgesetzt durch das zu behandelnde Teil (19) der Bauteiloberfläche (2) dicht verschlossen gehalten und das zu behandelnde Teil (19) zugleich der Wirkung der ionisierten Prozessgasteilchen ausgesetzt ist und
- aus der die Verschlusseinrichtung (21) nach erfolgter Behandlung des die Öffnung (15) dicht verschliessenden Teils (19) der Bauteiloberfläche (2) in die ihrerseits die Reaktionskammer (16) wieder abdichtend verschliessende Stellung zurückzubewegen ist, in der der portable autarke miniaturisierte ND-Plasma-Reaktor (1) ohne Abschaltung des in der Reaktionskammer (16) erzeugten Niederdruckplasmas zur unmittelbar fortgesetzten partiellen Behandlung eines anderen Teils (19) der Bauteiloberfläche (2) in Position zu bringen ist.

11. Vorrichtung nach Anspruch 10, **dadurch gekennzeichnet, dass** der portable autarke miniaturisierte ND-Plasma-Reaktor (1) mehrere über eine flexible Leitung mit dem Prozessgasbehälter (10) und der Vakuumpumpe (9) verbundene Reaktionskammern (16) aufweist, die gleichzeitig zur partiellen Behandlung der Oberfläche (2) eines und/oder mehrerer Bauteile (3) einzusetzen sind.

12. Vorrichtung nach Anspruch 10 oder 12, **dadurch gekennzeichnet,dass** die Verschlusseinrichtung (21) für die Öffnung (15) der Reaktionskammer (16) robotergesteuert in die Schliess- und in die Freigabestellung zu bewegen ist.

13. Vorrichtung nach einem der Ansprüche 10 bis 12, **dadurch gekennzeichnet, dass** die Verschlusseinrichtung (21) eine Schiebetür oder ein Shutter ist.

14. Vorrichtung nach einem der Ansprüche 10 bis 13, **dadurch gekennzeichnet, dass** der portable autarke miniaturisierte ND-Plasma-Reaktor (1) in der Schliessstellung und in der Freigabestellung der Verschlusseinrichtung (21) für die Öffnung (15) der Reaktionskammer (16) mittels eines Luftkissens relativ zur die Bauteiloberfläche (2) zu bewegen ist, wobei das Luftkissen zugleich eine Abdichtung der Reaktionskammer (16) gegenüber der Bauleiloberfläche (2) bildet.

15. Vorrichtung nach einem der Ansprüche. 10 bis 14, **dadurch gekennzeichnet, dass** der portable autarke miniaturisierte ND-Plasma-Reaktor (1) mittels eines Roboters zu bewegen ist.

16. Vorrichtung nach Anspruch15, **dadurch gekennzeichnet, dass** der Reaktionsgasbehälter (10), die Vakuumpumpe (9) und die mindestens eine Reaktionskammer (16) des portablen autarken miniaturisierten ND-Plasmareaktors (1) mittels des Roboters gehaltert und relativ zueinander zu bewegen sind.

17. Vorrichtung nach einem der Ansprüche 10 bis 16, **dadurch gekennzeichnet, dass** in Behandlungsstellung der Reaktionskammer (16) die Verschlusseinrichtung für die Öffnung (15) der Reaktionskammer (16) in Schliessstellung unmittelbar oberhalb des zu behandelnden Teils (19) der Bauteiloberfläche (2) angeordnet, ist, wobei beim Bewegen der Verschlusseinrichtung (21) in ihre Freigabestellung Leckageströme des ionisierten Prozessgases zu vernachlässigen sind.

18. Vorrichtung nach einem der Ansprüche 10 bis 17, **dadurch gekennzeichnet, dass** die Abmessungen der Reaktionskammer (16) bezüglich ihrer Länge, Breite und Höhe im Bereich von 10 mm bis 100 mm bzw. 10 mm bis 100 mm bzw 10 mm bis 100 mm liegen.

19. Vorrichtung nach einem der Ansprüche 10 bis 18, **dadurch gekennzeichnet, dass** der Einsatzdruck in der Reaktionskammer (16) im Bereich von 1 Pa bis 1000 Pa liegt.

## Claims

1. A method for the partial treatment of the surface at least of one component with low pressure plasma, which is to be produced in at least one reaction chamber provided with an opening, wherein the opening of the reaction chamber is closed and the reaction chamber is then evacuated and filled with a process gas which through application of energy into the reaction chamber is ionized therein with the formation of the low pressure plasma and is brought into effect on the part of the surface of the component which is to be treated,
**characterized in that**
- at least one portable self-sufficient miniaturized open LP-plasma reactor is used,
- wherein the opening of the reaction chamber of the LP-plasma reactor is held tightly closed by a closure arrangement, to be moved into a closed position, before the start of the surface treatment, whereupon
- the process gas is filled into the reaction chamber, which is closed by the closure arrangement, and is ionized therein by means of microwave stimulation,
- the closure arrangement is then moved into a position exposing the opening of the reaction chamber, in which the opening of the reaction chamber is now continued to be tightly closed by the part of the component surface which is to be treated, and the ionized process gas comes to act on the part of the component surface which is to be treated,
- the closure arrangement, after completed treatment of the part of the component surface closing the opening of the reaction chamber, is moved back into its closed position and
- then the miniaturized LP-plasma reactor, without disconnection of the low pressure plasma produced in the reaction chamber, is brought into the corresponding position for the immediately continued partial treatment of another part of the component surface.

2. The method according to Claim 1, **characterized in that** the dimensions of the reaction chamber of the portable self-sufficient miniaturized LP-plasma reactor are selected with regard to its length, width and height in the range of 10 mm to 100 mm or respectively 10 mm to 100 mm or respectively 10 mm to 100 mm.

3. The method according to Claim 1 and 2, **characterized in that** the operation pressure in the reaction chamber of the portable self-sufficient miniaturized LP-plasma reactor is selected in the range of 1 Pa to 1000 Pa.

4. The method according to Claim 1 to 3, **characterized in that** the portable self-sufficient miniaturized LP-plasma reactor is moved in a robot-controlled manner.

5. The method according to Claim 4, **characterized in that** the closure arrangement for the opening of the reaction chamber of the portable self-sufficient miniaturized LP-plasma reactor is moved in a robot-controlled manner into the closed and the exposure position.

6. The method according to one of the preceding claims, **characterized in that** a sliding door or a shutter is used as closure arrangement.

7. The method according to one of Claims 1 to 6, **characterized in that** the portable self-sufficient LP-plasma reactor is moved by means of air cushions relative to the surface of the component before or after closure of the opening of the reaction chamber.

8. The method according to one of Claims 1 to 7, **characterized in that** the reaction chambers of several portable self-sufficient miniaturized LP-plasma reactors are moved simultaneously on the surface of the component or of various components for their partial treatment.

9. The method according to one of the preceding claims, **characterized in that** respectively a portable self-sufficient miniaturized LP-plasma reactor is used simultaneously on the opposite surfaces of a relatively thin opaque sheet of polyethylene for its treatment, wherein air is used as carrier medium in the reaction chamber, communicating with the vacuum pump and the process gas container, of the respective portable self-sufficient miniaturized LP-plasma reactor.

10. A device for the partial treatment of the surface (2) of a component (3) with low pressure plasma, which has at least one closable reaction chamber (16), provided with an opening (15), which chamber is connected via ducts (7, 8), respectively having a valve arrangement (5, 6), with a vacuum pump (9) and with a process gas container (10), from which the reaction chamber (16) is to be evacuated or respectively is to be filled with process gas, and on which a plasma generator (11) is provided externally, by means of which the process gas, filled into the evacuated reaction chamber (16), is to be ionized with the formation of the low pressure plasma in the reaction chamber (16), so that the ionized process gas can act on a part (19) of the component surface (2) which is to be treated,
**characterized in that**
- at least one portable self-sufficient miniaturized LP-plasma reactor (1) is available, in which
- a closure arrangement (21) is provided on the reaction chamber (16) which is to be moved into a closure position tightly closing the opening (15) of the reaction chamber (16), in which the reaction chamber (16) is to be evacuated and is to be filled with process gas,
- the plasma generator (11) is a microwave-, radio frequency wave- or other HF generator, by which the process gas is to be ionized in the reaction chamber (16) which is tightly closed by the closure arrangement (21), and
- the closure arrangement (21) is to be moved into a position exposing the opening (15) of the reaction chamber (16), in which the opening (15) of the reaction chamber (16) is held tightly closed continuously by the part (19) of the component surface (2) to be treated, and the part (19) to be treated is exposed at the same time to the action of the ionized process gas particles and
- from which the closure arrangement (21) after completed treatment of the part (19) of the component surface (2) tightly closing the opening (15) is to be moved back into the position in turn again closing the reaction chamber (16) in a sealing manner, in which the portable self-sufficient miniaturized LP-plasma reactor (1), without disconnection of the low pressure plasma produced in the reaction chamber (16) is to be brought into position for the directly continued partial treatment of another part (19) of the component surface (2).

11. The device according to Claim 10, **characterized in that** the portable self-sufficient miniaturized LP-plasma reactor (1) has several reaction chambers (16) connected via a flexible duct with the process gas container (10) and the vacuum pump (9), which chambers are to be used simultaneously for the partial treatment of the surface (2) of one and/or more components (3).

12. The device according to Claim 10 or 12, **characterized in that** the closure arrangement (21) for the opening (15) of the reaction chamber (16) is to be moved in a robot-controlled manner into the closed position and into the exposure position.

13. The device according to one of Claims 10 to 12, **characterized in that** the closure arrangement (21) is a sliding door or a shutter.

14. The device according to one of Claims 10 to 13, **characterized in that** the portable self-sufficient miniaturized LP-plasma reactor (1) in the closed position and in the exposure position of the closure arrangement (21) for the opening (15) of the reaction chamber (16) is to be moved by means of an air cushion relative to the component surface (2), wherein the air cushion at the same time forms a seal of the reaction chamber (16) with respect to the component surface (2).

15. The device according to one of Claims 10 to 14, **characterized in that** the portable self-sufficient miniaturized LP-plasma reactor (1) is to be moved by means of a robot.

16. The device according to Claim 15, **characterized in that** the reaction gas container (10), the vacuum pump (9) and the at least one reaction chamber (16) of the portable self-sufficient miniaturized LP-plasma reactor (1) are secured by means of the robot and are to be moved relative to each other.

17. The device according to one of Claims 10 to 16, **characterized in that** in the treatment position of the reaction chamber (16), the closure arrangement for the opening (15) of the reaction chamber (16) is arranged in closed position immediately above the part (19) of the component surface (2) which is to be treated, wherein on movement of the closure arrangement (21) into its exposure position, leakage flows of the ionized process gas are negligible.

18. The device according to one of Claims 10 to 17, **characterized in that** the dimensions of the reaction chamber (16) with regard to its length, width and height lie in the range of 10 mm to 100 mm or respectively 10 mm to 100 mm or respectively 10 mm to 100 mm.

19. The device according to one of Claims 10 to 18, **characterized in that** the operation pressure in the reaction chamber (16) lies in the range of 1 Pa to 1000 Pa.

## Revendications

1. Procédé de traitement partiel de la surface d'au moins un composant avec un plasma à basse pression, qui est généré dans au moins une chambre de réaction pourvue d'une ouverture, dans lequel l'ouverture de la chambre de réaction est fermée et la chambre de réaction est ensuite évacuée et est remplie d'un gaz de processus, qui est ionisé par apport d'énergie dans la chambre de réaction en formant le plasma à basse pression dans celle-ci et est amené à agir sur la partie à traiter de la surface du composant,
**caractérisé en ce que**
- au moins un réacteur à plasma à basse pression ouvert miniaturisé autonome portable est employé,
- dans lequel l'ouverture de la chambre de réaction du réacteur à plasma à basse pression avant de recevoir le traitement de surface est maintenue fermée de manière étanche par un dispositif de fermeture à déplacer dans une position de fermeture, après quoi
- la chambre de réaction fermée par le dispositif de fermeture est remplie de gaz de processus et celui-ci est ionisé au moyen d'une excitation par micro-ondes,
- le dispositif de fermeture est ensuite déplacé dans une position débloquant l'ouverture de la chambre de réaction, dans laquelle l'ouverture de la chambre de réaction est à présent maintenue fermée de manière étanche en continu par la partie à traiter de la surface de composant et le gaz de processus ionisé est amené à agir sur la partie à traiter de la surface de composant,
- le dispositif de fermeture après un traitement réussi de la partie de la surface de composant fermant l'ouverture de la chambre de réaction est redéplacé dans sa position de fermeture et
- le réacteur à plasma à basse pression miniaturisé est amené dans la position correspondante sans extinction du plasma à basse pression généré dans la chambre de réaction à des fins de traitement partiel direct en continu d'une autre partie de la surface de composant.

2. Procédé selon la revendication 1, **caractérisé en ce que** les dimensions de la chambre de réaction du réacteur à plasma à haute pression miniaturisé autonome portable sont sélectionnées en ce qui concerne leur longueur, largeur et hauteur dans la plage de 10 mm à 100 mm, resp. 10 mm à 100 mm, resp. 10 mm à 100 mm.

3. Procédé selon la revendication 1 ou 2, **caractérisé en ce que** la pression d'utilisation dans la chambre de réaction du réacteur à plasma à basse pression miniaturisé autonome portable est sélectionnée dans la plage de 1 Pa à 1000 Pa.

4. Procédé selon les revendications 1 à 3, **caractérisé en ce que** le réacteur à plasma à basse pression miniaturisé autonome portable est déplacé de manière commandée par un robot.

5. Procédé selon la revendication 4, **caractérisé en ce que** le dispositif de fermeture destiné à l'ouverture de la chambre de réaction du réacteur à plasma à basse pression miniaturisé autonome portable est déplacé de manière commandée par un robot dans la position de fermeture et la position de déblocage.

6. Procédé selon un des revendications précédentes, **caractérisé en ce que** une porte coulissante ou un volet obturateur est employé comme dispositif de fermeture.

7. Procédé selon une des revendications 1 à 6, **caractérisé en ce que** le réacteur à plasma à basse pression miniaturisé autonome portable est déplacé relativement à la surface du composant au moyen de coussins d'air avant ou après la fermeture de l'ouverture de la chambre de réaction.

8. Procédé selon une des revendications 1 à 7, **caractérisé en ce que** les chambres de réaction de plusieurs réacteurs à plasma à basse pression miniaturisés autonomes portables sont déplacées simultanément sur la surface du composant ou de composants différents en vue de leur traitement partiel.

9. Procédé selon une des revendications précédentes, **caractérisé en ce que** respectivement un réacteur à plasma à basse pression miniaturisé autonome portable est employé simultanément sur les surfaces opposées d'une plaque opaque relativement mince en polyéthylène à des fins de traitement de celle-ci, dans lequel de l'air est employé comme milieu porteur dans la chambre de réaction communiquant avec la pompe à vide et le récipient de gaz de processus du réacteur à plasma à basse pression miniaturisé autonome portable respectif.

10. Dispositif de traitement partiel de la surface (2) d'un composant (3) avec un plasma à basse pression, qui présente au moins une chambre de réaction (16) pouvant être fermée, pourvue d'une ouverture (15), laquelle est reliée à une pompe à vide (9) et à un récipient de gaz de processus (10) par l'intermédiaire de conduites (7,8) présentant respectivement un dispositif de soupape (5,6), par laquelle, resp. lequel la chambre de réaction (16) peut être évacuée, resp. remplie de gaz de processus et sur laquelle un générateur à plasma (11) est prévu à l'extérieur, au moyen duquel le gaz de processus remplissant la chambre de réaction (16) évacuée peut être ionisé en formant le plasma à basse pression dans la chambre de réaction (16), de telle sorte que le gaz de processus ionisé puisse agir sur une partie à traiter (19) de la surface du composant (2),
**caractérisé en ce que**
- au moins un réacteur à plasma à basse pression (1) miniaturisé autonome portable est disponible, dans lequel
- sur la chambre de réaction (16), un dispositif de fermeture (21) est prévu, lequel peut être déplacé dans une position de fermeture fermant de manière étanche l'ouverture (15) de la chambre de réaction (16), position dans laquelle la chambre de réaction (16) peut être évacuée et remplie d'un gaz de processus,
- le générateur de plasma (11) est un générateur à micro-ondes, à ondes de radiofréquence ou à autres hautes fréquences, par lequel le gaz de processus peut être ionisé dans la chambre de réaction (16) fermée de manière étanche par le dispositif de fermeture (21), et
- le dispositif de fermeture (21) peut être déplacé dans une position débloquant l'ouverture (15) de la chambre de réaction (16), dans laquelle l'ouverture (15) de la chambre de réaction (16) est maintenue fermée de manière étanche en continu par la partie à traiter (19) de la surface de composant (2), et la partie à traiter (19) est simultanément exposée à l'action des particules de gaz de processus ionisées, et
- à partir de laquelle le dispositif de fermeture (21) peut être redéplacé après un traitement réussi de la partie (19) de la surface de composant (2) fermant de manière étanche l'ouverture (15) dans la position fermant de son côté de nouveau de manière étanche la chambre de réaction (16), dans laquelle le réacteur à plasma à basse pression (1) miniaturisé autonome portable peut être amené en position sans extinction du plasma à basse pression généré dans la chambre de réaction (16) à des fins de traitement partiel en continu direct d'une autre partie (19) de la surface de composition (2).

11. Dispositif selon la revendication 10, **caractérisé en ce que** le réacteur à plasma à basse pression (1) miniaturisé autonome portable présente plusieurs chambres de réaction (16) reliées par l'intermédiaire d'une conduite flexible au récipient de gaz de processus (10) et à la pompe à vide (9), qui peuvent être employées simultanément à des fins de traitement partiel de la surface (2) d'un et/ou de plusieurs composants (3).

12. Dispositif selon la revendication 10 ou 12, **caractérisé en ce que** le dispositif de fermeture (21) destiné à l'ouverture (15) de la chambre de réaction (16) peut être déplacé de manière commandée par robot dans la position de fermeture et dans la position de déblocage.

13. Dispositif selon une des revendications 10 à 12, **caractérisé en ce que** le dispositif de fermeture (21) est une porte coulissante ou un volet obturateur.

14. Dispositif selon une des revendications 10 à 13, **caractérisé en ce que** le réacteur à plasma à basse pression (1) miniaturisé autonome portable peut être déplacé dans la position de fermeture et dans la position de déblocage du dispositif de fermeture (21) destiné à l'ouverture (15) de la chambre de réaction (16) au moyen d'un coussin d'air relativement à la surface du composant (2), dans lequel le coussin d'air forme simultanément une isolation étanche de la chambre de réaction (16) par rapport à la surface du composant (2).

15. Dispositif selon une des revendications 10 à 14, **caractérisé en ce que** le réacteur à plasma à basse tension (1) miniaturisé autonome portable peut être déplacé au moyen d'un robot.

16. Dispositif selon la revendication 15, **caractérisé en ce que** le récipient de gaz de réaction (10), la pompe à vide (9) et la au moins une chambre de réaction (16) du réacteur à plasma à basse pression (1) miniaturisé autonome portable peuvent être maintenus et déplacés l'un par rapport à l'autre au moyen du robot.

17. Dispositif selon une des revendications 10 à 16, **caractérisé en ce que** dans la position de traitement de la chambre de réaction (16), le dispositif de fermeture destiné à l'ouverture (15) de la chambre de réaction (16) est disposé dans la position de fermeture directement au dessus de la partie à traiter (19) de la surface de composant (2), dans lequel lors du déplacement du dispositif de fermeture (21) dans sa position de déblocage des courants de fuite du gaz de processus ionisé sont à négliger.

18. Dispositif selon une des revendications 10 à 17, **caractérisé en ce que** les dimensions de la chambre de réaction (16) en ce qui concerne sa longueur, largeur et hauteur sont comprises dans la plage de 10 mm à 100 mm , resp. de 10 mm à 100 mm, resp. de 10 mm à 100 mm.

19. Dispositif selon une des revendications 10 à 18, **caractérisé en ce que** la pression d'utilisation dans la chambre de réaction (16) est comprise dans la plage de 1 Pa à 1000 Pa.
